Europäisches Patentamt

European Patent Office

Office européen des brevets

(19)

(11) Publication number: **0 452 684 A1**

# EUROPEAN PATENT APPLICATION

(21) Application number: **91104218.2**

(22) Date of filing: **19.03.91**

(51) Int. Cl.⁵: **H03K 19/0175**, H03K 19/003,
H03K 19/0185, H03K 19/0948,
H03K 19/094

(30) Priority: **30.03.90 IT 1990290**

(43) Date of publication of application:
**23.10.91 Bulletin 91/43**

(84) Designated Contracting States:
**DE FR GB SE**

(71) Applicant: **SGS-THOMSON
MICROELECTRONICS s.r.l.**
**Via C. Olivetti, 2**
**I-20041 Agrate Brianza Milano(IT)**

(72) Inventor: **Dallabora, Marco**
**Via Bettoni, 24**
**I-20077 Melegnano, Milano(IT)**
Inventor: **Rolandi, Paolo**
**Via Ferzina, 5/A**
**I-15059 Volpedo, Alessandria(IT)**
Inventor: **Maccalli, Marco**
**Via Edison, 15**
**I-20026 Novate Milanese, Milano(IT)**

(74) Representative: **Perani, Aurelio et al**
**c/o JACOBACCI-CASETTA & PERANI Via
Visconti di Modrone 7**
**I-20122 Milano(IT)**

(54) **A reduced noise, data output stage of the buffer type for logic circuits of the CMOS type.**

(57) A reduced noise, data output stage (1) of the buffer type, intended for CMOS logic circuits, comprises pairs (5,6,7) of transistors (M1,M4,M2,M5,M3,M6) connected in parallel with one another between a pair of inputs (2,3) and a data output (4). These transistor pairs (5,6,7) are driven through respective resistive control lines including respective resistors (R1,R2) which are connected between corresponding gate electrodes of the first and the second transistor pairs, and of the second and the third transistor pairs, to reduce the value of the differential ratio dI/dt, while also reducing switching noise.

Fig.1

EP 0 452 684 A1

This invention relates to a reduced noise, data output stage of the buffer type for CMOS logic circuits, being of the type which comprises transistor pairs connected in parallel to one another between a pair of inputs and a data output.

It is a known fact that the above-outlined circuit arrangements are provided to prevent undesired electric interactions between a driver circuit and a driven circuit.

A first prior approach to the provision of buffers of this kind is disclosed, for example, in European Patent No. EP 0 284 357 to Toshiba.

This prior patent illustrates the structure of a driver circuit incorporating a large size CMOS inverter. The use of this inverter as a buffer involves problems from the high sensitivity of the circuit to switching noise.

A second prior approach is disclosed in European Patent No. 0 251 910 to Fujitzu, wherein the switching noise of a data output buffer is reduced by driving the gates of the driver circuit through a suitable RC circuit.

A major drawback of the latter approach originates from the reduced speed of the circuit as a whole.

Also known are other types of driver circuits which provide a pre-discharge step for the output which is brought to a logic high consistent with logics of the TTL type. This pre-discharge step is clocked by an internal clock to the circuit which is operated prior to enabling the buffer stage.

This known circuit does afford a reduction in noise on the output being switched from a logic high to a logic low, but has proved ineffective when switching the other way.

A further prior approach has proposed a buffer circuit comprising a pair of parallel-connected CMOS transistors which are turned on with a delay from an inverter pair.

A major drawback of the last-mentioned approach is the occupation of excessive circuit area at the expense of flexibility. In fact, that type of circuit requires a number of adjustments of the delay introduced by the inverters and of the transistor dimensions.

The technical problem underlying this invention is to provide a data output stage of the buffer type, which has such structural and functional characteristics as to reduce switching noise and overcome the above-mentioned drawbacks with which the prior art is beset.

The solutive idea on which the invention stands is one of reducing the time derivative of the switching current, that is the value of the differential value dI/dt.

Based on this solutive idea, the technical problem is solved by an output stage as indicated being characterized in that said transistor pairs are driven through respective resistive control lines.

The features and advantages of an output circuit stage according to the invention will become apparent from the following detailed description of an exemplary embodiment thereof, given by way of illustration and not of limitation with reference to the accompanying drawings.

In the drawings:

Figure 1 is a circuit diagram of the output stage according to the invention; and

Figures 2 to 4 show respective comparative plottings of the voltage and current values appearing in the stage of Figure 1 and in circuits according to the prior art.

With reference to the drawing figures, generally indicated at 1 is a data output stage of the buffer type embodying this invention and intended for high switching rate, CMOS-type logic circuits.

The stage 1 comprises a pair of signal inputs 2 and 3 and an output 4.

The construction of stage 1 is quite straightforward and comprises basically three pairs of transistors connected in parallel to one another.

In the exemplary embodiment illustrated, such transistors are all of the n-channel MOS type.

A first pair 5 comprises transistors M1 and M4 having their respective gate electrodes G1 and G4 connected to corresponding inputs 2 and 3.

The source S1 of transistor M1 is connected to the drain D4 of transistor M4.

A second pair 6 comprises transistors M2 and M5 connected to each other by way of the source S2 of M2 and the drain D5 of M5.

This second pair 6 is connected in parallel with the first pair 5 through the links between their respective drain and source electrodes, and specifically D1 with D2, S1 with S2, D4 with D5, and S4 with S5.

A third pair 7 of MOS transistors M3 and M6 completes the stage 1. This third pair 7 is, in turn, connected in parallel with the second pair 6 and is arranged to have the transistors M3 and M6 interconnected by way of the link between the source S3 and the drain D6.

Advantageously according to the invention, the second and third transistor pairs are driven through resistive control lines which introduce a predetermined delay in the turning on of the transistors in each pair.

Provided for the purpose are respective resistors R1 connected between the inputs 2, 3 and the gates G2, G5 of the second transistor pair 6.

Further respective resistors R2 connect each gate G2 and G5 to a corresponding gate G3 and G6 of the third transistor pair 7.

The inputs 2 and 3 are instead connected directly to, and driven by, an output of an amplifier, not shown because conventional.

Advantageously, the dimensions of the transistor pairs increase from the first pair onwards.

In addition, the values of the resistors R1 and R2 are selected to be in the order of kiloOhms, thereby a delay of approximately 2 nsec is applied to the turn-on of the last stage, consisting of the third pair M3 and M6, so as to substantially balance the capacitances of the transistors M2 and M3, which are on the order of hundreds picoFarads.

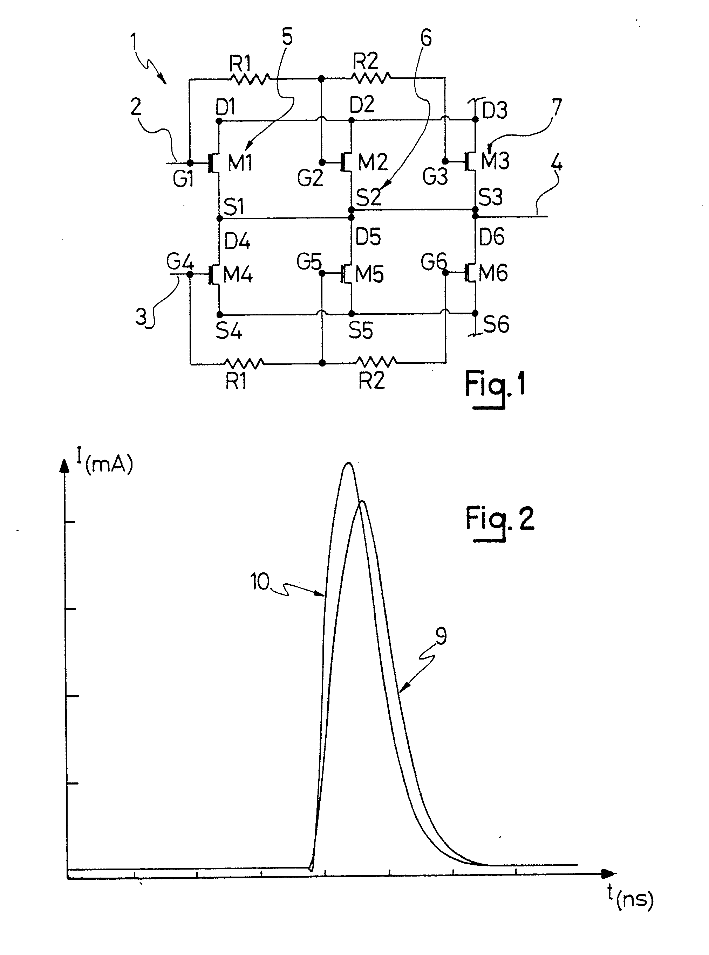

The output stage of this invention will be only retarded, therefore, by 2 nsec over buffer circuits of known type. However, actual tests carried out by the Applicant have demonstrated that the value of the differential ratio dI/dt, of the output current to time, drops for the circuit under consideration to 5 mA/nsec as shown in Figure 2.

The behavior may be appreciated from that figure of the current peak 9 versus time, as present on switching the inventive circuit, compared with a corresponding curve 10 depicting the behavior of that same quantity in a buffer circuit according to the prior art.

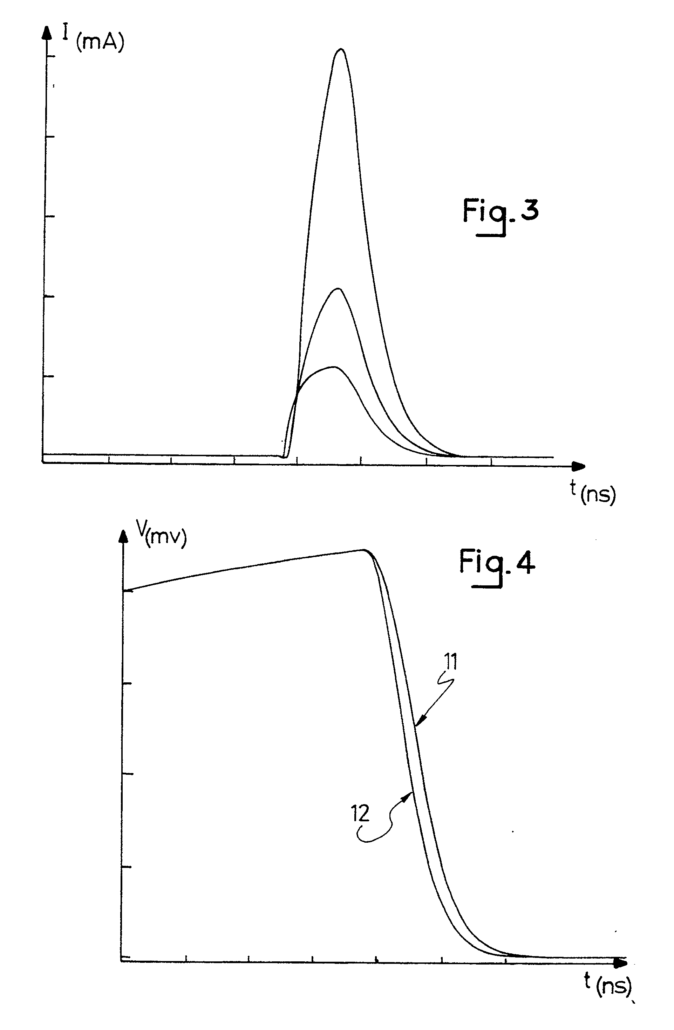

Figure 3 shows instead the behaviors of the current curves versus time appearing during the switching phase on the respective transistors M4, M5 and M6.

All this reflects in a reduction of the ground noise, which goes from about 640 mV to 400 mV with control devices having a word length of 16 bits.

The voltage appearing on the output 4 has a behavior over time as shown by curve 11 in Figure 4, where it is compared with curve 12 from a buffer circuit according to the prior art.

It may be appreciated from the foregoing that the output stage of this invention affords selection of the most favorable compromise between the delay in signal propagation and the ground noise during the switching phase. This can be achieved by appropriate selection of the resistor values.

**Claims**

1. A reduced noise, data output stage (1) of the buffer type for CMOS logic circuits, being of the type which comprises transistor (M1,M4,M2,M5,M3,M7) pairs (5,6,7) connected in parallel to one another between a pair of inputs (2,3) and a data output (4), characterized in that said transistor pairs (5,6,7) are driven through respective resistive control lines.

2. An output stage according to Claim 1, characterized in that said control lines comprise respective resistors (R1,R2) connected between each transistor pair (5,6,7).

3. An output stage according to Claim 1, characterized in that it comprises three pairs of n-channel MOS transistors.

4. An output stage according to Claim 3, characterized in that said pairs of MOS transistors have increasing dimensions from the first thereof connected to said inputs (2,3).

5. An output stage according to Claim 4, characterized in that it comprises respective resistors (R1,R2) connected between the corresponding gate electrodes (G1,G2,G4,G5) of the first (5) and second (6) pairs, and of the second (6) and third (7) pairs of transistors.

Fig.1

Fig. 2

4

Fig.3

Fig.4

## DOCUMENTS CONSIDERED TO BE RELEVANT

EP 91104218.2

| Category | Citation of document with indication, where appropriate, of relevant passages | Relevant to claim | CLASSIFICATION OF THE APPLICATION (Int. Cl.5) |
|---|---|---|---|
| A | EP - A1 - 0 172 350<br>(FUJITSU LIMITED)<br>* Totality * | 1 | H 03 K 19/0175<br>H 03 K 19/003<br>H 03 K 19/0185<br>H 03 K 19/0948<br>H 03 K 19/094 |
| D,A | EP - A2/A3 - 0 251 910<br>(FUJITSU LIMITED)<br>* Totality * | 1 | |
| A | EP - A1 - 0 261 528<br>(KABUSHIKI KAISHA TOSHIBA)<br>* Totality * | 1 | |
| D,A | EP - A2/A3 - 0 284 357<br>(KABUSHIKI KAISHA TOSHIBA)<br>* Fig. 1,8 * | 1 | |

TECHNICAL FIELDS
SEARCHED (Int. Cl.5)

H 03 K 19/00

The present search report has been drawn up for all claims

| Place of search | Date of completion of the search | Examiner |
|---|---|---|
| VIENNA | 15-07-1991 | BAUMANN |